# EUROPEAN PATENT APPLICATION

(11) **EP 4 757 084 A1**
(43) Date of publication of application: **10.06.2026**
(21) Application number: 25191076.6
(22) Date of filing: 22.07.2025
(51) Int. Cl.: H01S 5/34, H01S 5/343

(54) **LASER DIODES AND STRAIN COMPENSATED QUANTUM DOT LAYERS**

(30) Priority: 04.12.2024 US 202418968740
(71) Applicant: II-VI Delaware, Inc., Wilmington, DE 19890 (US)
(72) Inventor: LEHKONEN, Sami, Wilmington, 19890 (US); CHEN, Young-Kai, Wilmington, 19890 (US); TANBUN-EK, Tawee, Wilmington, 19890 (US)
(74) Representative: Schmidt, Christian

(57) **Abstract**

A laser diode includes an active region, confinement layers, and cladding layers. The active region includes one or more active layers that each exert a first strain in a first direction and one or more strain compensating layer that each exert a second strain in a second direction that is opposite the first direction. The confinement layers bound the active region. The cladding layers bound the confinement layers. In some embodiments, each active layer comprises InAs quantum dots in a InᵣGa₁₋ᵣAs quantum well, where 0 ≤ r ≤ 1; and each strain compensating layer comprises a GaAs₁₋ₛPₛ layer, where 0 < s ≤ 1. The confinement layers may each comprise a (Al_{Z}Ga_{1-Z})_{W}ln_{1-W}P layer, where 0 < w < 1 and 0 ≤ z < 1. The cladding layers may each comprise a (Al_{y}Ga_{1-y})ₓIn₁₋ₓP layer, where 0 < x < 1 and 0 ≤ y < 1.

## Description

### TECHNICAL FIELD

Aspects of the present disclosure relate to lasing structures such as laser diodes.

### BACKGROUND

One conventional approach of constructing a laser diode includes embedding indium arsenide (InAs) quantum dots (QD) within an indium gallium arsenide (InGaAs) quantum well (QW) and using an aluminum gallium arsenide (AlGaAs) based lattice to confine such InAs quantum dots (QD). See, *e.g.,* "InAs/InGaAs/GaAs quantum dot lasers of 1.3 µm range with enhanced optical gain", A.R. Kovsh et al. / Journal of Crystal Growth 251 (2003) 729-736. However, this approach introduces compressive strain between lattice structures of the respective layers. Historically, such strain has been controlled by limiting the number of QD layers, limiting thicknesses of strained layers, and using thicker spacer layers to avoid strain induced defects. However, such remedial measures also limit the number of InAs QD layers and range of achievable lasing wavelengths. Forgoing and/or limiting the usage of such remedial measures creates heavy strain which commonly leads to reliability issues for the resulting laser diodes.

Moreover, using AlGaAs as a confinement material for laser active regions results in a confinement material with a high Al-content in order to provide the high confinement required of QD lasers. However, high Al-content causes manufacturability and reliability issues due to strong oxidation of Al containing materials. One approach for addressing the reliability issues associated with Al-containing materials is to use an Al-free active region as described in U.S. Patent No. 5,889,805 to Botez et al. in regard to a quantum well laser diode suitable for lasing ~ 800 to 870 nanometer (nm) wavelengths.

Further limitations and disadvantages of conventional and traditional approaches will become apparent to one of skill in the art, through comparison of such approaches with some aspects of the present disclosure as set forth in the remainder of the present application with reference to the drawings.

### BRIEF SUMMARY OF THE DISCLOSURE

Shown in and/or described in connection with at least one of the figures, and set forth more completely in the claims, are laser diodes and associated processes for manufacturing laser diodes. Various embodiments of the laser diodes may include strain compensated indium arsenide quantum dots confined with phosphide materials. Such strain compensation may permit stacking multiple layers of quantum dots in order to provide longer lasing wavelengths (*e.g.,* 1300 (nm) nanometers, 1350 nm, *etc*.). Moreover, confinement via phosphide materials may permit reducing the quantity of aluminum (Al) and associated negative effects of aluminum oxidation.

These and other advantages, aspects and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 depicts an embodiment of a laser diode in accordance with various aspects of the present disclosure.
FIG. 2 depicts another embodiment of a laser diode in accordance with various aspects of the present disclosure.
FIG. 3 depicts a graph comparing strain of a conventional laser diode to a laser diode comprising one or more strain compensating layers.
FIG. 4 depicts a graph comparing aluminum content of two confinement materials and their respective band gap at different quantities of aluminum.

### DESCRIPTION

The following discussion provides various examples of laser diodes and associated processes for manufacturing laser diodes. In some embodiments, the laser diodes include strain compensated indium arsenide quantum dots confined with phosphide materials. Such examples are non-limiting, and the scope of the appended claims should not be limited to the particular examples disclosed. In the following discussion, the terms "example" and "*e.g.*" are non-limiting.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Various embodiments are directed to lasing structures which may be described as laser diodes. In particular, the laser diodes may include an active region bounded by a waveguide or optical confinement layers. The active region may include one or more active layers and one or more strain compensating layers. Each active layer may include quantum dots within a quantum well. The laser diodes may also include cladding layers which bound the confinement layers. In various embodiments, the respective layers have essentially homogeneous properties and may be deposited or grown on a semiconductor substrate.

The active region and confinement layers may form a laser cavity characterized by a cavity length, a cavity width, and a cavity height. The latter being essentially the total thickness of the active region between the confinement layers. Each end of the cavity may provide a facet through which light is emitted from the laser diode.

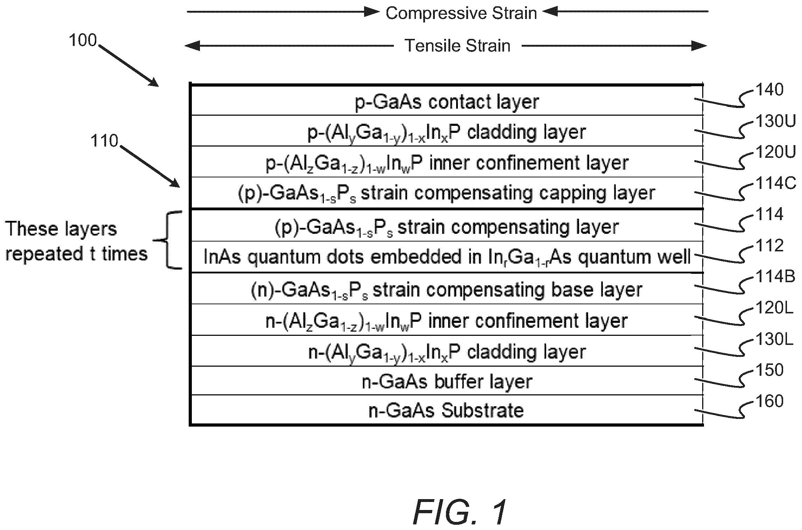

Referring now to FIG. 1, an embodiment of a laser diode 100 in accordance with various aspects of the present disclosure is shown. As shown, the laser diode 100 may include an active region 110, confinement layers 120U, 120L, cladding layers 130U, 130L, contact layer 140, buffer layer 150, and semiconductor bulk substrate 160.

The semiconductor bulk substrate 160 may comprise a gallium arsenide (GaAs) substrate. The semiconductor bulk substrate 160 may include a bulk substrate top surface and a bulk substrate bottom surface opposite the bulk substrate top surface. The other layers of the laser diode 100 may be epitaxially grown, stacked, and/or otherwise formed upon the bulk substrate top surface.

The buffer layer 150 may comprise a layer of the same semiconductor material as the semiconductor bulk substrate 160. Namely, the buffer layer 150 may comprise a layer of GaAs having a GaAs layer top surface and a GaAs layer bottom surface opposite the GaAs top surface. The GaAs layer may be epitaxially grown, stacked, or otherwise formed on the bulk substrate top surface such that the GaAs layer bottom surface covers and contacts the bulk substrate top surface. In particular, a lattice structure of the buffer layer 150 may align with and continue a lattice structure of the semiconductor bulk substrate 160.

The active region 110 may bounded by an upper confinement layer 120U and a lower confinement layer 120L, which in turn may be bounded by an upper cladding layer 130U and a lower cladding layer 130L. The active region 110 may include one or more active layers 112 and one or more strain compensating layers 114. Each active layer 112 may comprise indium arsenide (InAs) quantum dots embedded in a quantum well of an indium gallium arsenide (InᵣGa₁₋ᵣAs) alloy, where 0 ≤ r ≤ 1. One or more strain compensating layers 114 may bound each active layer 112 such that a bottom surface of one of the strain compensating layers 114 contacts a top surface of a respective active layer 112 and a top surface of another one of the strain compensating layers 114 contacts a bottom surface the respective active layer 112.

Due to lattice structure mismatch between the one or more active layers 112 and other layers of the laser diode 100, each active layer 112 may exert a compressive strain upon the laser diode 100. Thus, increasing the number of active layers 112 increases the accumulative compressive strain exerted by the active layers 112 on the laser diode 100. However, if the compressive strain is too great, the strain may affect the structural integrity of the laser diode 100 and/or reduce its reliability.

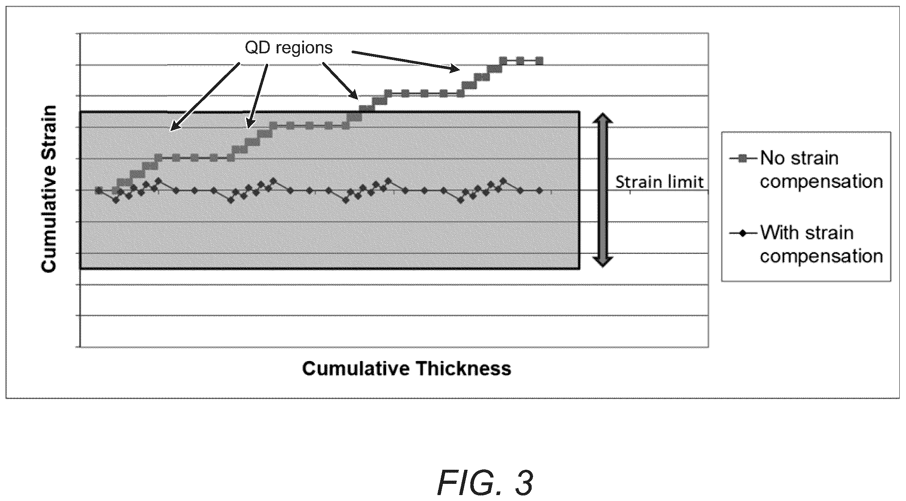

To counteract such negative effects of the compressive strain of the active layers 112, the laser diode 100 includes the one or more strain compensating layers 114. In particular, the strain compensating layers 114, due to lattice structure mismatch with other layers, exert a tensile strain on the laser diode 100. In short, each active layer 112 may exert strain in a first direction and each strain compensating layers 114 may exert strain in a second direction that is opposite the first direction. Thus, by alternating active layers 112 and strain compensating layers 114 in the laser diode stack, the strain provided by the strain compensating layers 114 may effectively cancel the strain exerted by the active layers 112. See, *e.g.,* FIG. 3.

As such, the active layer 112 and strain compensating layers 114 of the active region 110 may be repeated several times (*e.g.,* t ≥ 1). For example, the active region 110 may be implemented with two, three, four, etc. alternating active layers 112 and strain compensating layers 114 (*e.g.,* a first active layer 112, a first strain compensating layer 114 on the first active layer 112, a second active layer 112 on the first strain compensating layer 114, a second strain compensating layer 114 on the second active layer 112, and so on). Moreover, the laser diode 100 may be implemented with a greater number of active layers 112 than may be otherwise possible if constructed without such strain compensating layers 114. A greater number of active layers 112 and thus a thicker active region 110 may improve performance of the resulting laser diode 100. As such, the laser diode 100 with its greater number of active layers 112 may produce lasing light of a greater wavelength (*e.g.,* 1300 nm, 1350 nm, *etc*.) and/or of greater performance characteristics than what may be achieved by conventional laser diode stacks with fewer active layers and/or thinner active regions.

In addition to the repeated strain compensating layers 114, the active region 110 may include a strain compensating base layer 114B and a strain compensating capping layer 114C. The strain compensating base layer 114B and the strain compensating capping layer 114C may each be implemented in a similar manner as the repeated strain compensating layers 114 of the active region 110, but may respectively provide a foundation (base) and a cap for the active region 110. In particular, the strain compensating base layer 114B may comprise a strain compensating base layer bottom surface that defines a bottom surface of the active region 110, and the strain compensating capping layer 114C may comprise a strain compensating capping layer top surface that defines a top surface of the active region 110.

As noted, the active region 110 may be bounded by the confinement layers 120U, 120L. The upper confinement layer 120U and the lower confinement layer 120L may each comprise a layer of aluminum gallium indium phosphide ((Al_{z}Ga_{1-z})_{1-w}In_{w}P), where 0 < w < 1 and 0 ≤ z < 1. In particular, the lower confinement layer 120L may have a lower confinement layer top surface and a lower confinement layer bottom surface opposite the lower confinement top surface. The lower confinement layer 120L may be epitaxially grown, stacked, or otherwise formed on the lower cladding layer 130L, described below, such that the lower confinement layer bottom surface covers and contacts the lower cladding layer top surface. Conversely, the upper confinement layer 120U may have an upper confinement layer top surface and an upper confinement layer bottom surface opposite the upper confinement top surface. The upper confinement layer 120U may be epitaxially grown, stacked, or otherwise formed on the active region 110 such that the upper cladding layer bottom surface covers and contacts a top surface of the active region 110.

As noted, the confinement layers 120U, 120L may be bounded by cladding layers 130U, 130L. In particular, the upper cladding layer 130U and the lower cladding layer 130L may each comprise a layer of aluminum gallium indium phosphide ((Al_{y}Ga_{1-y})₁₋ₓInₓP), where 0 < x < 1 and 0 ≤ y < 1. The lower cladding layer 130L may have a lower cladding layer top surface and a lower cladding layer bottom surface opposite the lower cladding layer top surface. The lower cladding layer 130L may be epitaxially grown, stacked, or otherwise formed on the buffer layer 150 such that the lower cladding layer bottom surface covers and contacts the buffer layer top surface. Conversely, the upper cladding layer 130U may have an upper cladding layer top surface and an upper cladding layer bottom surface opposite the upper cladding layer top surface. The upper cladding layer 130U may be epitaxially grown, stacked, or otherwise formed on the upper confinement layer 120U such that the upper cladding layer bottom surface covers and contacts an upper confinement layer top surface.

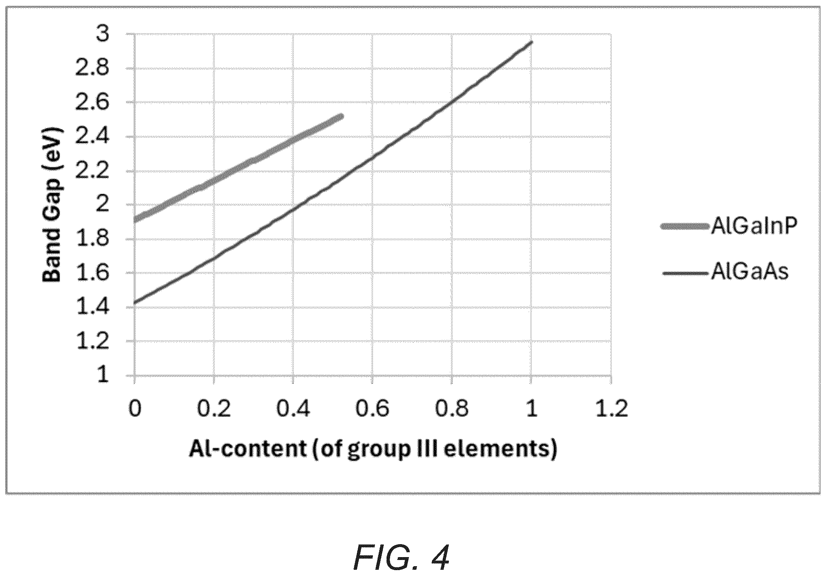

Using AlGaInP-based materials as confinement layers 120U, 120L, and cladding layers 130U, 130L may reduce the quantity of aluminum around the active region 110. As shown in FIG. 4, AlGaInP-based materials may provide similar bandgaps as AlGaAs-based materials, but at a lower aluminum content. As noted above, high aluminum content causes manufacturability and reliability issues due to strong oxidation of aluminum containing materials. By using AlGaInP-based materials instead of AlGaAs-based materials, the laser diode 100 may be implemented with less aluminum about the active region 110, thus reducing oxidation about the active region 110 and the associated negative effects.

The contact layer 140 may comprise a layer of gallium arsenide (GaAs) on the upper confinement layer 120U. In particular, the contact layer 140 may include a contact layer top surface and a contact layer bottom surface opposite the contact layer top surface. The contact layer 140 may be epitaxially grown, stacked, or otherwise formed such that the contact layer bottom surface covers and contacts the upper confinement layer top surface. The contact layer 140 may generally provide an electrical contact via which a driving current may drive the active region 110 to emit lasing light via a facet of the laser diode 100.

The semiconductor bulk substrate 160, the buffer layer 150, the lower cladding layer 130L, and the lower confinement layer 120L may be n-doped so as to provide n-type materials below the active region 110. Conversely, the upper confinement layer 120U, the upper cladding layer 130U, and upper contact layer 140 may be p-doped so as to provide p-type material above the active region 110. Moreover, the values of x, y, w, z of the confinement layers 120U, 120L, and the cladding layers 130U, 130L are selected such that the cladding layers 130U, 130L have a higher energy bandgap than the confinement layers 120U, 120L.

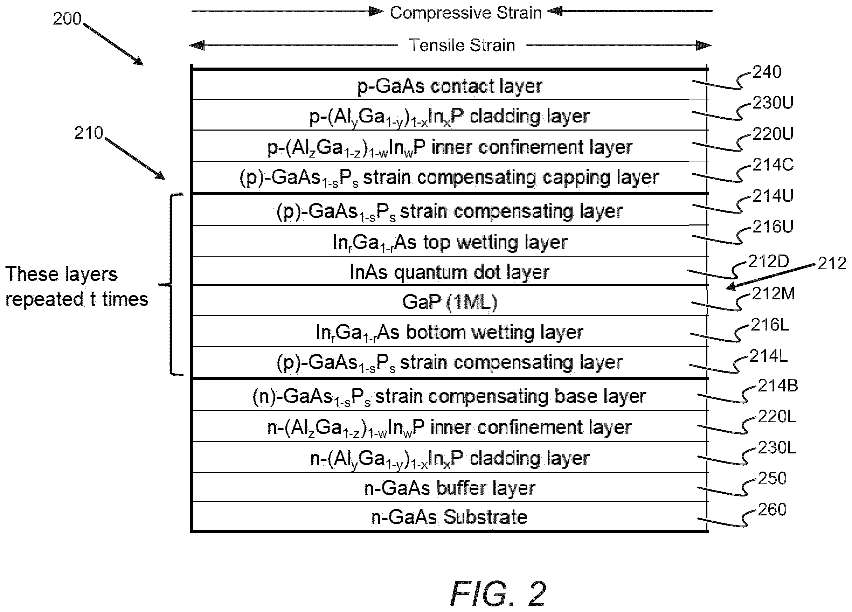

Referring now to FIG. 2, an embodiment of a laser diode 200 in accordance with various aspects of the present disclosure is shown. As shown, the laser diode 200 may include an active region 210, confinement layers 220U, 220L, cladding layers 230U, 230L, contact layer 240, buffer layer 250, and semiconductor bulk substrate 260.

The semiconductor bulk substrate 260 may comprise a gallium arsenide GaAs substrate. The semiconductor bulk substrate 260 may include a bulk substrate top surface and a bulk substrate bottom surface opposite the bulk substrate top surface. The other layers of the laser diode 200 may be epitaxially grown, stacked, and/or otherwise formed upon the bulk substrate top surface.

The buffer layer 250 may comprise a layer of the same semiconductor material as the semiconductor bulk substrate 260. Namely, the buffer layer 250 may comprise a layer of GaAs having a GaAs layer top surface and a GaAs layer bottom surface opposite the GaAs top surface. The GaAs layer may be epitaxially grown, stacked, or otherwise formed on the bulk substrate top surface such the GaAs layer bottom surface covers and contacts the bulk substrate top surface. In particular, a lattice structure of the buffer layer 250 may align with and continue a lattice structure of the semiconductor bulk substrate 260.

The active region 210 may bounded by an upper confinement layer 220U and a lower confinement layer 220L, which in turn may be bounded by an upper cladding layer 230U and a lower cladding layer 230L. The active region 210 may include one or more active layers 212 that are each bounded an upper strain compensating layer 214U and a lower strain compensating layer 214L. In particular, each active layer 212 may comprise a semiconductor monolayer 212M and a quantum dot layer 212D. The semiconductor monolayer 212M may comprise a monolayer of gallium phosphide (GaP) having a monolayer top surface and a monolayer bottom surface opposite the monolayer top surface. Further, the quantum dot layer 212D may comprise quantum dots of InAs which are epitaxially grown, stacked, or otherwise formed on the top surface of the semiconductor monolayer 212M.

The upper strain compensating layer 214U may be epitaxially grown, stacked, or otherwise formed over a respective active layer 212 such that a bottom surface of the upper strain compensating layer 214U covers and contacts a top surface of the respective active layer 212. However, in some embodiments, an upper wetting layer 216U of InᵣGa₁₋ᵣAs, where 0 ≤ r ≤ 1, may be epitaxially grown, stacked, or otherwise formed on the top surface of the respective active layer 212 and the upper strain compensating layer 214U may be epitaxially grown, stacked, or otherwise formed on the top surface of the upper wetting layer 216u.

The monolayer 212M may be epitaxially grown, stacked, or otherwise formed over a top surface of a lower strain compensating layer 214L such that a bottom surface of the monolayer 212M covers and contacts a lower strain compensating layer top surface. However, in some embodiments, a lower wetting layer 216L of InᵣGa₁₋ᵣAs, where 0 ≤ r ≤ 1, may be epitaxially grown, stacked, or otherwise formed on the top surface of the lower strain compensating layer 214L and the monolayer 212M may be epitaxially grown, stacked, or otherwise formed on the top surface of the lower wetting layer 216L.

Due to lattice structure mismatch between the one or more active layers 212 and other layers of the laser diode 200, each active layer 212 may exert a compressive strain upon the laser diode 200. Thus, increasing the number of active layers 212 increases the accumulative compressive strain exerted by the active layers 212 on the laser diode 200. However, if the compressive strain is too great, the strain may affect the structural integrity of the laser diode 200 and/or reduce its reliability.

To counteract such negative effects of the compressive strain of the active layers 212, the laser diode 200 includes strain compensating layers 214U, 214L. In particular, the strain compensating layers 214U, 214L, due to lattice structure mismatch with other layers, exert a tensile strain on the laser diode 200. In short, each active layer 212 may exert strain in a first direction and each strain compensating layers 214U, 214L may exert strain in a second direction that is opposite the first direction. Thus, by alternating active layers 212 and bounding strain compensating layers 214U, 214L in the laser diode stack, the strain provided by the strain compensating layers 214U, 214L may effectively cancel the strain exerted by the active layers 212. See, e.g., FIG. 3.

As such, the active layer 212 and strain compensating layers 214U, 214L of the active region 210 may be repeated several times (*e.g.,* t ≥ 1). For example, the active region 110 may be implemented with two, three, four, etc. alternating active layers 212 and strain compensating layers 214U, 214L (*e.g.*, a first lower strain compensating layer 214L, a first active layer 212 on the first lower strain compensating layer 214L, a first upper strain compensating layer 214U on the first active layer 212, a second lower strain compensating layer 214L on the first upper strain compensating layer 214U, a second active layer 212 on the second lower strain compensating layer 214L, a second upper strain compensating layer 214U on the second active layer 212, and so on). Moreover, the laser diode 200 may be implemented with a greater number of active layers 212 than may be otherwise possible if constructed without such strain compensating layers 214U. 214L. A greater number of active layers 212 and thus a thicker active region 210 may improve performance of the resulting laser diode 200. As such, the laser diode 200 with its greater number of active layers 212 may produce lasing light of a greater wavelength (*e.g.,* 1300 nm, 1350 nm, *etc*.) and/or of greater performance characteristics than what may be achieved by conventional laser diode stacks with fewer active layers and/or thinner active regions.

In addition to the repeated strain compensating layers 214U, 214L, the active region 210 may include a strain compensating base layer 214B and a strain compensating capping layer 214C. The strain compensating base layer 214B and the strain compensating capping layer 214C may each be implemented in a similar manner as the repeated strain compensating layers 214 of the active region, but may respectively provide a foundation (base) and a cap for the active region 210. In particular, the strain compensating base layer 214B may comprise a strain compensating base layer bottom surface that defines a bottom surface of the active region 210, and the strain compensating capping layer 214C may comprise a strain compensating capping layer top surface that defines a top surface of the active region 210.

As noted, the active region 210 may be bounded by the confinement layers 220U, 220L. The upper confinement layer 220U and the lower confinement layer 220L may each comprise a layer of (Al_{z}Ga_{1-z})_{1-w}In_{w}P, where 0 < w < 1 and 0 ≤ z < 1. In particular, the lower confinement layer 220L may have a lower confinement layer top surface and a lower confinement layer bottom surface opposite the lower confinement top surface. The lower confinement layer 220L may be epitaxially grown, stacked, or otherwise formed on the lower cladding layer 230L, described below, such that the lower confinement layer bottom surface covers and contacts the lower cladding layer top surface. Conversely, the upper confinement layer 220U may have an upper confinement layer top surface and an upper confinement layer bottom surface opposite the upper confinement top surface. The upper confinement layer 220U may be epitaxially grown, stacked, or otherwise formed on the active region 210 such that the upper cladding layer bottom surface covers and contacts a top surface of the active region 210.

As noted, the confinement layers 220U, 220L may be bounded by cladding layers 230U, 230L. In particular, the upper cladding layer 230U and the lower cladding layer 230L may each comprise a layer of (Al_{y}Ga_{1-y})₁₋ₓInₓP, where 0 < x < 1 and 0 ≤ y < 1. The lower cladding layer 230L may have a lower cladding layer top surface and a lower cladding layer bottom surface opposite the lower cladding layer top surface. The lower cladding layer 230L may be epitaxially grown, stacked, or otherwise formed on the buffer layer 250 such that the lower cladding layer bottom surface covers and contacts the buffer layer top surface. Conversely, the upper cladding layer 230U may have an upper cladding layer top surface and an upper cladding layer bottom surface opposite the upper cladding layer top surface. The upper cladding layer 230U may be epitaxially grown, stacked, or otherwise formed on the upper confinement layer 220U such that the upper cladding layer bottom surface covers and contacts an upper confinement layer top surface.

Using AlGaInP-based materials as confinement layers 220U, 220L, and cladding layers 230U, 230L may reduce the quantity of aluminum around the active region 210. As shown in FIG. 4, AlGaInP-based materials may provide similar bandgaps as AlGaAs-based materials, but at a lower aluminum content. As noted above, high aluminum content causes manufacturability and reliability issues due to strong oxidation of aluminum containing materials. By using AlGaInP-based materials instead of AlGaAs-based materials, the laser diode 200 may be implemented with less aluminum about the active region 210, thus reducing oxidation about the active region 210 and the associated negative effects.

The contact layer 240 may comprise a layer of GaAs on the upper confinement layer 220U. In particular, the contact layer 240 may include a contact layer top surface and a contact layer bottom surface opposite the contact layer top surface. The contact layer 240 may be epitaxially grown, stacked, or otherwise formed such that the contact layer bottom surface covers and contacts the upper confinement layer top surface. The contact layer 240 may generally provide an electrical contact via which a driving current may drive the active region 210 to emit lasing light via a facet of the laser diode 200.

The semiconductor bulk substrate 260, the buffer layer 250, the lower cladding layer 230L, the lower confinement layer 220L may be n-doped so as to provide n-type materials below the active region 210. Conversely, the upper confinement layer 220U, the upper cladding layer 230U, and upper contact layer 240 may be p-doped so as to provide p-type material above the active region 210. Moreover, the values of x, y, w, z of the confinement layers 220U, 220L and the cladding layers 230U, 230L are selected such that the cladding layers 230U, 230L have a higher energy bandgap than the confinement layers 220U, 220L.

The present application claims priority of US patent application 18/968,740, which was filed on December 4, 2024. The entire disclosure content of this application is incorporated herein for all purposes.

Implementations described herein may relate to the following: A laser diode includes an active region, confinement layers, and cladding layers. The active region includes one or more active layers that each exert a first strain in a first direction and one or more strain compensating layer that each exert a second strain in a second direction that is opposite the first direction. The confinement layers bound the active region. The cladding layers bound the confinement layers. In some embodiments, each active layer comprises InAs quantum dots in a InᵣGa₁₋ᵣAs quantum well, where 0 ≤ r ≤ 1; and each strain compensating layer comprises a GaAs₁₋ₛPₛ layer, where 0 < s ≤ 1. The confinement layers may each comprise a (Al_{z}Ga_{1-z})_{w}In_{1-w}P layer, where 0 < w < 1 and 0 ≤ z < 1. The cladding layers may each comprise a (Al_{y}Ga_{1-y})ₓIn₁₋ₓP layer, where 0 < x < 1 and 0 ≤ y < 1.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:
1. A laser diode, comprising:
   an active region comprising one or more active layers that each exert a first strain in a first direction and one or more strain compensating layer that each exert a second strain in a second direction that is opposite the first direction;
   an upper confinement layer and a lower confinement layer bounding a top surface and a bottom surface of the active region; and
   an upper cladding layer and a lower cladding layer bounding a top surface of the upper confinement layer and a bottom surface of the lower confinement layer.
2. The laser diode of item 1, wherein each active layer comprises quantum dots in a quantum well.
3. The laser diode of item 1, wherein:
   the first strain is a compressive strain; and
   the second strain is a tensile strain.
4. The laser diode of item 1, wherein the one or more active layers and the one or more strain compensating layers are stacked upon one another.
5. The laser diode of item 1, wherein:
   a first strain compensating layer of the one or more strain compensating layers covers and contacts a top surface of a first active layer of the one or more active layers and; and
   a second strain compensating layer of the one or more strain compensating layers covers and contacts a bottom surface of the first active layer of the one or more active layers.
6. The laser diode of item 1, wherein:
   each active layer comprises InAs quantum dots in a InᵣGa₁₋ᵣAs quantum well, where 0 ≤ r ≤ 1; and
   each strain compensating layer comprises a GaAs₁₋ₛPₛ layer, where 0 < s ≤ 1.
7. The laser diode of item 6, wherein:
   the upper confinement layer and the lower confinement layer each comprise a (Al_{z}Ga_{1-z})_{w}In_{1-w}P layer, where 0 < w < 1 and 0 ≤ z < 1; and
   the upper cladding layer and the lower cladding layer each comprise a (Al_{y}Ga_{1-y})ₓIn₁₋ₓP layer, where 0 < x < 1 and 0 ≤ y < 1.
8. The laser diode of item 1, wherein:
   each active layer comprises:
      a lower wetting layer of InᵣGa₁₋ᵣAs, where 0 ≤ r ≤ 1;
      a GaP layer on the lower wetting layer;
      an InAs quantum dot layer on the GaP layer; and
      an upper wetting layer of wetting layer of InᵣGa₁₋ᵣAs, where 0 ≤ r ≤ 1; and
   each strain compensating layer comprises GaAs₁₋ₛPₛ, where 0 < s ≤ 1.
9. The laser diode of item 8, wherein the upper confinement layer and the lower confinement layer each comprise a (Al_{z}Ga_{1-z})_{w}In_{1-w}P layer, where 0 < w < 1 and 0 ≤ z < 1.
10. The laser diode of item 9, wherein the upper cladding layer and the lower cladding layer each comprise a (Al_{y}Ga_{1-y})ₓIn₁₋ₓP layer, where 0 < x < 1 and 0 ≤ y < 1.
11. The laser diode of item 1, comprising a semiconductor bulk substrate of n₋type GaAs.
12. The laser diode of item 1, wherein:
   the upper cladding layer and the upper confinement layer are p-type; and
   the lower cladding layer and the lower confinement layer are n-type.
13. A lasing structure, comprising:
   a semiconductor substrate;
   a lower cladding layer over the semiconductor substrate;
   a lower confinement layer over the lower cladding layer;
   a first strain compensating layer over the lower cladding layer;
   a first active layer comprising quantum dots over the first strain compensating layer;
   a second strain compensating layer over the first active layer;
   an upper confinement layer over the second strain compensating layer; and
   an upper cladding layer over the upper confinement layer;
   wherein the first active layer exerts a compressive strain on the lasing structure; and
   wherein the first strain compensating layer and the second strain compensating layer each exert a tensile strain on the lasing structure.
14. The lasing structure of item 13, wherein:
   the first active layer comprises a quantum well; and
   the quantum dots are in the quantum well.
15. The lasing structure of item 13, comprising:
   a plurality of second active layers over the second strain compensating layer, wherein each second active layer includes quantum dots; and
   a plurality of third strain compensating layers over the second strain compensating layer, wherein one or more layers of the plurality of third strain compensating layers separate second active layers of the plurality of second active layers.
16. The lasing structure of item 13, wherein:
   the first active layer comprises InAs quantum dots in a InᵣGa₁₋ᵣAs quantum well, where 0 ≤ r ≤ 1; and
   the first strain compensating layer and the second strain compensating layer each comprise a GaAs₁₋ₛPₛ layer, where 0 < s ≤ 1.
17. The lasing structure of item 16, wherein the upper confinement layer and the lower confinement layer each comprise a (Al_{z}Ga_{1-z})_{w}In_{1-w}P layer, where 0 < w < 1 and 0 ≤ z < 1.
18. The lasing structure of item 17, wherein the upper cladding layer and the lower cladding layer each comprises a (Al_{y}Ga_{1-y})ₓIn₁₋ₓP layer, where 0 < x < 1 and 0 ≤ y < 1.
19. The lasing structure of item 13, wherein:
   the first active layer comprises:
      a lower wetting layer of InᵣGa₁₋ᵣAs, where 0 ≤ r ≤ 1;
      a GaP layer on the lower wetting layer;
      an InAs quantum dot layer on the GaP layer; and
      an upper wetting layer of wetting layer of InᵣGa₁₋ᵣAs, where 0 ≤ r ≤ 1; and
   the first strain compensating layer and the second strain compensating layer each comprises a GaAs₁₋ₛPₛ layer, where 0 < s ≤ 1.
20. The lasing structure of item 13, wherein the semiconductor substrate is a GaAs substrate.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.

## Claims

1. A laser diode, comprising:
an active region comprising one or more active layers that each exert a first strain in a first direction and one or more strain compensating layer that each exert a second strain in a second direction that is opposite the first direction;
an upper confinement layer and a lower confinement layer bounding a top surface and a bottom surface of the active region; and
an upper cladding layer and a lower cladding layer bounding a top surface of the upper confinement layer and a bottom surface of the lower confinement layer.

2. The laser diode of claim 1, wherein each active layer comprises quantum dots in a quantum well.

3. The laser diode of claim 1 or 2, wherein:
the first strain is a compressive strain; and
the second strain is a tensile strain.

4. The laser diode of any one of the preceding claims, wherein the one or more active layers and the one or more strain compensating layers are stacked upon one another.

5. The laser diode of any one of the preceding claims, wherein:
a first strain compensating layer of the one or more strain compensating layers covers and contacts a top surface of a first active layer of the one or more active layers and; and
a second strain compensating layer of the one or more strain compensating layers covers and contacts a bottom surface of the first active layer of the one or more active layers.

6. The laser diode of any one of the preceding claims, wherein:
each active layer comprises InAs quantum dots in a InᵣGa₁₋ᵣAs quantum well, where 0 ≤ r ≤ 1; and
each strain compensating layer comprises a GaAs₁₋ₛPₛ layer, where 0 < s ≤ 1.

7. The laser diode of claim 6, wherein:
the upper confinement layer and the lower confinement layer each comprise a (Al_{z}Ga_{1-z})_{w}In_{1-w}P layer, where 0 < w < 1 and 0 ≤ z < 1; and
the upper cladding layer and the lower cladding layer each comprise a (Al_{y}Ga_{1-y})ₓIn₁₋ₓP layer, where 0 < x < 1 and 0 ≤ y < 1.

8. The laser diode of any one of the preceding claims, wherein:
each active layer comprises:
a lower wetting layer of InᵣGa₁₋ᵣAs, where 0 ≤ r ≤ 1;
a GaP layer on the lower wetting layer;
an InAs quantum dot layer on the GaP layer; and
an upper wetting layer of wetting layer of InᵣGa₁₋ᵣAs, where 0 ≤ r ≤ 1; and
each strain compensating layer comprises GaAs₁₋ₛPₛ, where 0 < s ≤ 1.

9. The laser diode of any one of the preceding claims, wherein the upper confinement layer and the lower confinement layer each comprise a (Al_{z}Ga_{1-z})_{w}In_{1-w}P layer, where 0 < w < 1 and 0 ≤ z < 1.

10. The laser diode of any one of the preceding claims, wherein the upper cladding layer and the lower cladding layer each comprise a (Al_{y}Ga_{1-y})ₓIn₁₋ₓP layer, where 0 < x < 1 and 0 ≤ y < 1.

11. The laser diode of any one of the preceding claims, comprising a semiconductor bulk substrate of n₋type GaAs.

12. The laser diode of any one of the preceding claims, wherein:
the upper cladding layer and the upper confinement layer are p-type; and
the lower cladding layer and the lower confinement layer are n-type.

13. A lasing structure, comprising:
a semiconductor substrate;
a lower cladding layer over the semiconductor substrate;
a lower confinement layer over the lower cladding layer;
a first strain compensating layer over the lower cladding layer;
a first active layer comprising quantum dots over the first strain compensating layer;
a second strain compensating layer over the first active layer;
an upper confinement layer over the second strain compensating layer; and
an upper cladding layer over the upper confinement layer;
wherein the first active layer exerts a compressive strain on the lasing structure; and
wherein the first strain compensating layer and the second strain compensating layer each exert a tensile strain on the lasing structure.

14. The lasing structure of claim 13,
a) wherein:
the first active layer comprises a quantum well; and
the quantum dots are in the quantum well, and/or
b) comprising:
a plurality of second active layers over the second strain compensating layer, wherein each second active layer includes quantum dots; and
a plurality of third strain compensating layers over the second strain compensating layer, wherein one or more layers of the plurality of third strain compensating layers separate second active layers of the plurality of second active layers, and/or
c) wherein:
the first active layer comprises InAs quantum dots in a InᵣGa₁₋ᵣAs quantum well, where 0 ≤ r ≤ 1; and
the first strain compensating layer and the second strain compensating layer each comprise a GaAs₁₋ₛPₛ layer, where 0 < s ≤ 1, and/or
d) wherein the upper confinement layer and the lower confinement layer each comprise a (Al_{z}Ga_{1-z})_{w}In_{1-w}P layer, where 0 < w < 1 and 0 ≤ z < 1, and/or
e) wherein the upper cladding layer and the lower cladding layer each comprises a (Al_{y}Ga_{1-y})ₓIn₁₋ₓP layer, where 0 < x < 1 and 0 ≤ y < 1, and/or
f) wherein:
the first active layer comprises:
a lower wetting layer of InᵣGa₁₋ᵣAs, where 0 ≤ r ≤ 1;
a GaP layer on the lower wetting layer;
an InAs quantum dot layer on the GaP layer; and
an upper wetting layer of wetting layer of InᵣGa₁₋ᵣAs, where 0 ≤ r ≤ 1; and
the first strain compensating layer and the second strain compensating layer each comprises a GaAs₁₋ₛPₛ layer, where 0 < s ≤ 1.

15. The lasing structure of claim 13 or 14, wherein the semiconductor substrate is a GaAs substrate.
